## Europäisches Patentamt

## European Patent Office

## Office européen des brevets

(11) Numéro de publication: **0 091 342**
**B1**

(12) # FASCICULE DE BREVET EUROPEEN

(45) Date de publication du fascicule du brevet:
**26.02.86**

(21) Numéro de dépôt: **83400604.1**

(22) Date de dépôt: **23.03.83**

(51) Int. Cl.⁴: **H 01 L 29/60, H 01 L 29/64, H 01 L 21/28**

(54) Procédé de réalisation d'un transistor à effet de champ du type planar à grille supplémentaire enterrée.

(30) Priorité: **02.04.82 FR 8205781**

(43) Date de publication de la demande:
**12.10.83 Bulletin 83/41**

(45) Mention de la délivrance du brevet:
**26.02.86 Bulletin 86/9**

(84) Etats contractants désignés:
**DE GB NL**

(56) Documents cités:
**EP - A - 0 006 001**
**FR - A - 2 302 592**
**US - A - 4 249 190**

**IBM TECHNICAL DISCLOSURE BULLETIN, vol. 24, no. 2, juillet 1981, pages 997-998, New York, USA, R.A. MUGGLI: "Double gate bipolar compatible N-channel junction FET"**

(73) Titulaire: **THOMSON-CSF, 173, Boulevard Haussmann, F-75379 Paris Cedex 08 (FR)**

(72) Inventeur: **Jay, Paul Robert, THOMSON-CSF SCPI 173, bld Haussmann, F-75379 Paris Cedex 08 (FR)**
Inventeur: **Rumelhard, Christian, THOMSON-CSF SCPI 173, bld Haussmann, F-75379 Paris Cedex 08 (FR)**

(74) Mandataire: **Lepercque, Jean et al, THOMSON-CSF SCPI 173, Bld Haussmann, F-75379 Paris Cedex 08 (FR)**

LIBER, STOCKHOLM 1986

L'invention concerne un frocidi de fabrication d'un transistor à effet de champ du type plan ou "planar" comportant une grille dans le plan commun aux 3 électrodes (source, grille et drain) et une grille supplémentaire enterrée dans la couche active mais accessible dymis lidit plan commun.

Cette grille supllémentaire peut être raccordée à la première de façon permanente, par une connexion de résistance nulle ou quasi-nulle ; elle peut être aussi utilisée en grille auxiliaire, comme dans un transistor de type "bigrille".

On connaît des transistors à effet de champ à deux grilles :
— du type planar, où les deux grilles sont disposées en parallèle dans le même plan ;
— du type à canal horizontal avec grille supplémentaire (placée sous le dispositif), qui a été proposé par J.C. VOKES et al dans la revue "Electronic Letters" Année 1979 Vol. 15, pages 627–629.

Il est connu par le document EP-A-0 006 001 de réaliser un transistor à effet de champ possédant une électrode de grille supplémentaire noyée dans le matériau semi-conducteur du transistor. Cette élektrode de grille est reliée à une zone de contact accessible depuis le plan dans liguil se tronvent le électrode de souver, de drain et d'une première grille. Ce transistor est élaboré selon un procédé assez complexe faisant intervenir deux substrats.

On connaît aussi des transistors à canal vertical ou P.B.T (permeable base transistor) dans lesquels le contrôle du courant est effectué par une grille présentant des mailles enterrées dans le matériau semiconducteur.

Le brevet US-A-4 249 190 divulgue un transistor à effet de champ à canal vertical qui dispose. d'électrodes de grille supplémentaires mais cellesci sont flottantes au lieu d'être accessibles par la face supérieure.

Or, chacune de ces solutions présente des inconvénients dont les principales sont :
— pour les transistors planar, l'augmentation de la résistance d'accès aux grilles à partir de la source ou du drain, en raison de l'espacement supplémentaire nécessaire pour loger les deux électrodes parallèles de grille entre source et drain, cette résistance supplémentaire étant particulièrement gênante en très haute fréquence ;
— pour le transistor de VOKES, il faut supprimer le substrat pour pouvoir déposer la deuxième grille sur la face arrière et résoudre un problème difficile d'alignement.
— pour le transistor à canal vertical, la technologie de fabrication particulièrement délicate et complexe.

L'invention vise à remédier à ces inconvénients.

L'invention a donc pour objet un procédé de fabrication d'un transistor à effet de champ du type comportant des électrodes de source, de grille et de drain disposées sensiblement sur une même face d'une plaquette semiconductrice et comportant également une électrode de grille supplémentaire accessible par la même face que les électrodes précédentes, ladite grille supplémentaire étant constituée par au moins un barreau métallique noyé dans le matériau semi-conducteur de la plaquette et par un plot de raccordement, caractérisé en ce qu'il comporte les étapes suivantes :

a) formation d'une couche épitaxiale de forte résistivité sur une plaquette semi-conductrice de forte résistivité,

b) réalisation, sur la couche formée à l'étape (a), de dépôts en métal réfractaire de très faible épaisseur, de façon à constituer la grille supplémentaire et deux repères de dessins différents,

c) formation d'une couche épitaxiale de faible résistivité par rapport à la couche formée à l'étape (a), l'épaisseur de cette couche de faible résistivité étant suffisamment faible et la largeur du barreau métallique suffisamment petite par rapport aux dimensions du plot de raccordement, pour que sa croissance épitaxiale permettent le racouvrement du barreau métallique tout en laissant à nu au moins une partie dudit plot et des deux repères,

d) dépôt de contacts ohmiques de source et de drain sur la couche épitaxiée à l'étape (c),

e) dépôt d'une grille Schottky sur la couche épitaxiale formée à l'étape (c), en vis-à-vis du barreau métallique de la grille supplémentaire.

L'invention sera mieux comprise, et d'autres caractéristiques apparaîtront, au moyen de la description qui suit, et des dessins qui l'accompagnent, parmi lesquels :

La figure 1 est une représentation simplifiée à trois dimensions d'un transistor n'alisé selon le procidi de l'invention ;

Les figures 2 à 5 représentent des étapes de fabrication de ce transistor.

La figure 6 est une coupe transversale d'un transistor réalisé selon le procédéde l'invention.

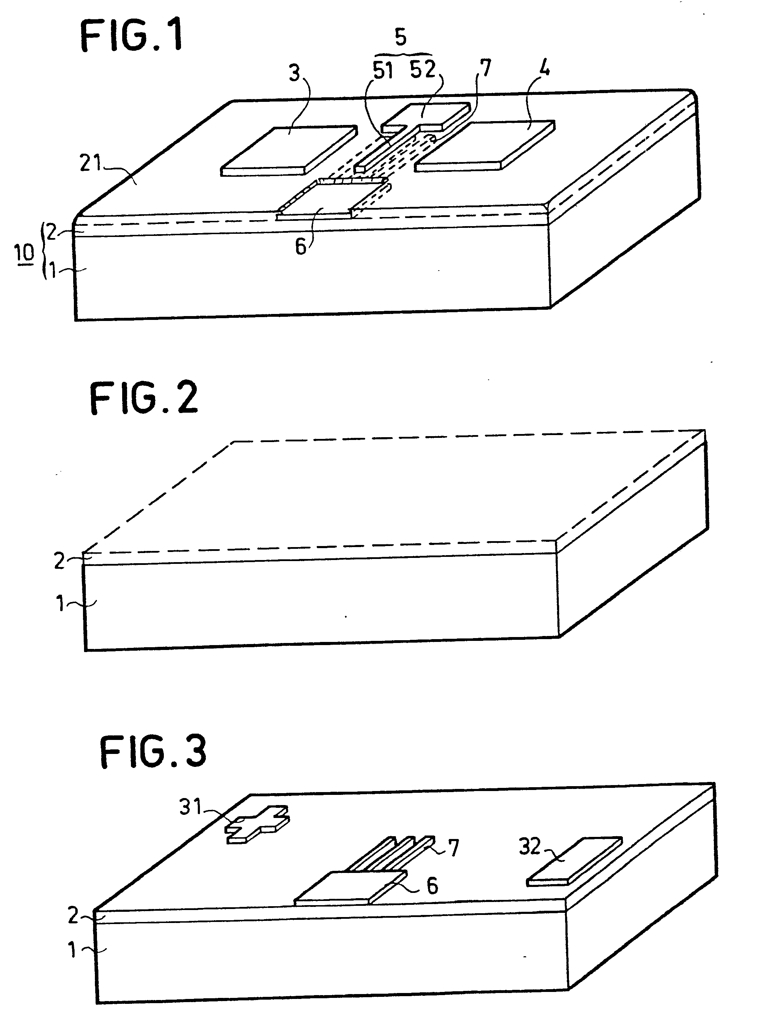

La plaquette ou fragment de plaquette semiconductrice 10, sur la figure 1, comporte un substrat 1 en matériau semiconducteur par exemple du type des composés III-V, soit, typiquement, l'arséniure de gallium. Une couche épitaxiale 2 de forte résistivité, est déposée sur le substrat 1 et supporte une électrode de grille consituée d'un plot 6 de raccordement et de barreaux ou doigts 7 en continuité métallique avec le plot 6, les barreaux étant parallèles et situés dans l'espace destiné à devenir l'intervalle source-drain du transistor.

Les dimensions du plot 6 sont, au minimum, de 50 microns sur 50 microns, et les doigts 7 ont une largeur d'environ 0,5 micron.

Sur la couche 2, on a fait croître par épitaxie une couche 21 de type n, dopée par exemple à $10^{17}$ atomes d'impureté par centimètre cube. Dans le cas des dimensions indiquées pour le plot 6 et les doigts 7, seul le plot 6 n'est pas recouvert par la couche 21 qui présente par exemple 0,3 micron d'épaisseur.

Enfin le transistor comporte une source 3, une grille 5 et un drain 4, comme un transistor à effet de champ classique. La grille 5 comporte un doigt 51 et un plot de raccordement 52.

Pour fabriquer ce transistor on utilise un procédé comportant les étapes suivantes:

Dans une première étape, on dépose par épitaxie (figure 2) une couche monocristalline 2 sur un substrat 1, en matériau constitué par exemple par de l'arséniure de gallium de très grande résistivité, dit pour cette raison "semi-isolant", mais pouvant être aussi constitué par un autre composé III-V de très grande résistivité. Par épitaxie en phase gazeuse, par exemple, on fait croître le monocristal pour former une couche 2 de forte résistivité et d'épaisseur de l'ordre de 5 microns, par exemple en Ga As dopé n à $10^{13}$ atomes/cm³.

Dans une deuxième étape (figure 3), on réalise des dépôts en métal réfractaire, tel que le tungstène, d'une épaisseur de 50 à 100 nm selon des dessins prédéterminés, en procédant par masquage préalable et découpage du masque par photolithographie, pour obtenir, par exemple, un dépôt rectangulaire 6 de dimensions 50 par 50 microns. En outre on forme au moins un dépôt allongé 7 raccordé au dépôt 6 et formant un doigt de largeur 0,5 micron dont la longueur est égale à la "largeur" de grille à constituer pour la grille dite "supplémentaire". En outre, on forme deux repères 31 et 32 de dessins très différents, et de dimensions minimales égales à environ 15 à 20 microns dans les deux sens. Ces repères sont situés par exemple aux deux extrémités d'une diagonale du rectangle constitué par la surface supérieure du dispositif.

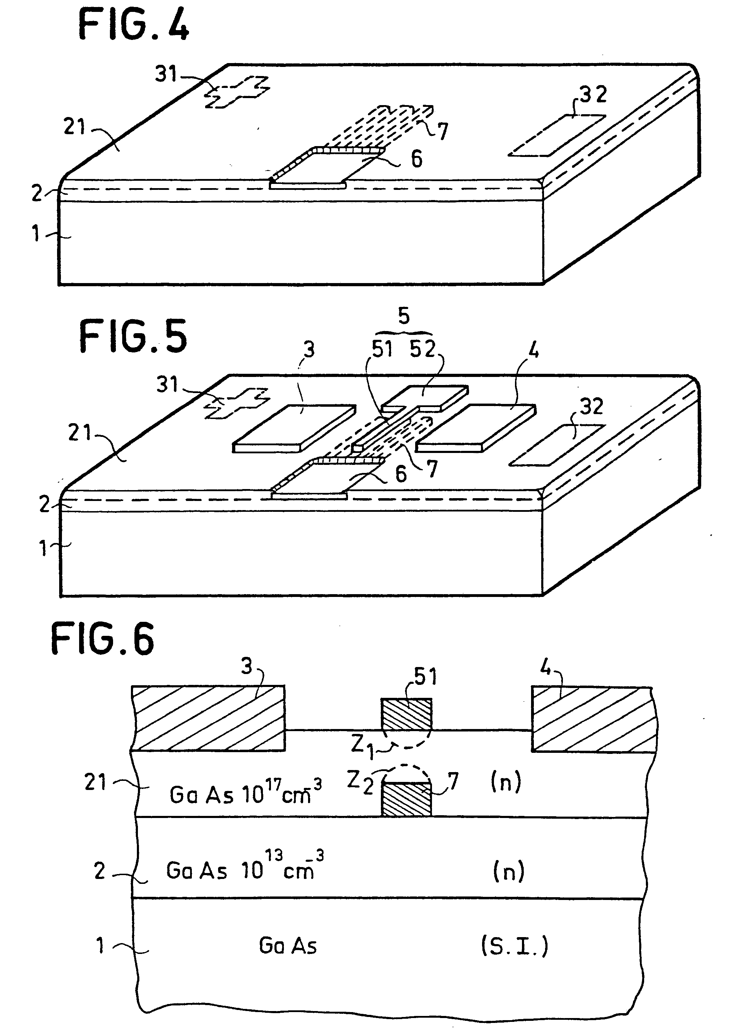

Dans une troisième étape (figure 4), on fait à nouveau croître le matériau par épitaxie de façon à constituer une couche 21 de même type de conductivité (n par exemple) que la couche 2 et de plus faible résistivité, par exemple en dopant l'arséniure de gallium à $10^{17}$ atomes par cm³. La croissance du matériau ne peut se produire, au moins au début de l'étape, à l'endroit même des métallisations. Lorsqu'une certaine épaisseur de couche épitaxiale est formée (300 nm par exemple,) il se forme rependant des ponts de matériaux, notamment au dessus des dépôts 7 de faible largeur (0,5 micron). Au contraire, le dépôt 6 et les repères 31 et 32 demeurent en grande partie découverts, laissant notamment accessible pour le raccordement électrique, la grille dite supplémentaire.

Dans une quatrième étape (figure 5), à l'aide d'un masque obtenu par photolithographie, on forme, par dépôts successifs de métaux tels que le nickel, le germanium et l'or, des contacts ohmiques 3 et 4, dans des zones prédéterminées située de part et d'autre de la région de grille du transistor à effet de champ, afin de réaliser les électrodes de source et de drain.

Dans une cinquième étape, (voir figure 5), on forme, par une méthode analogue à celle de l'étape précédente, mais en utilisant un métal de nature à former un contact de type Schottky, par exemple de l'aluminium, un dépôt métallique comportant un plot 52 et un prolongement digital 51, recouvrant la grille enterrée (6,7).

Sur la figure 6, on a représenté le cas d'une grille enterrée à un seul barreau 7, sité au droit du doigt 51. On a tracé en trait interrompu les limites des régions désertes $Z_1$ et $Z_2$ de la couche semiconductrice 21, au voisinage des doigts de grille 51 et 7, lorsque des potentiels égaux sont appliqués aux deux grilles. On voit que le canal conducteur du transistor á effet de champ présente un étranglement entre les deux grilles, ce qui présente des avantages certains, notamment celui de limiter la consommation de courant circulant entre source et drain.

## Revendications

1. Procédé de fabrication d'un transistor à effet de champ du type comportant des électrodes de source (3), de grille (5) et de drain (4) disposées sensiblement sur une même face d'une plaquette semi-conductrice (10) et comportant également une électrode de grille supplémentaire accessible par la même face que les électrodes précédentes, ladite grille supplémentaire étant constituée par au moins un barreau métallique (7) noyé dans le matériau semi-conducteur de la plaquette au droit de l'électrode de grille (5) et par un plot de raccordement (6), caractérisé en ce qu'il comporte les étapes suivantes:

a) formation d'une couche épitaxiale (2) de forte résistivité sur une plaquette semi-conductrice de forte résistivité,

b) réalisation, sur la couche formée à l'étape (a), de dépôts en métal réfractaire de très faible épaisseur, de façon à constituer la grille suplémentaire (6,7) et deux repères (31,32) de dessins différents,

c) formation d'une couche épitaxiale (21) de faible résistivité par rapport à la couche formée à l'étape (a), l'épaisseur de cette couche de faible résistivité étant suffisamment faible et la largeur du barreau métallique (7) suffisamment petite par rapport aux dimensions du plot de raccordement (6), pour que sa croissance épitaxiale permettent le recouvrement du barreau métallique (7) tout en laissant à nu au moins une partie dudit plot (6) et des deux repères (31,32),

d) dépôt de contacts ohmiques de source (3) et de drain (4) sur la couche (21) épitaxiée à l'étape (c),

e) dépôt d'une grille Schottky (5) sur la couche épitaxiale (21) formée à l'étape (c), en vis-à-vis du barreau métallique (7) de la grille supplémentaire.

2. Procédé de fabrication selon la revendication 1, caractérisé en ce que la plaquette semi-conductrice est en arséniure de gallium semi-isolant, la couche épitaxiale (2) formée à l'étape (a) est dopée n à $10^{13}$ atomes cm³, les dépôts métalliques réalisés à l'étape (b) sont en tungstène d'une épaisseur de 50 à 100 nm, et la couche épitaxiale (21) formée à l'étape (c) est dopée à $10^{17}$ atomes/cm³ et d'une épaisseur ne dépassant pas 300 nm.

## Patentansprüche

1. Verfahren zur herstellung eines Feldeffekttransistors vom Typ mit Source-(3), Gate-(5) und Drain-Elektrode (4), welche im wesentlichen auf derselben Fläche einer Halbleiterscheibe (10) angeordnet sind, und mit einer zusätzlichen Gate-Elektrode, die über dieselbe Fläche wie die vorgenannten Elektroden zugänglich ist, wobei dieses zusätzliche Gate gebildet ist aus wenigstens einem Metallstäbchen (7), welches in das Halbleitermaterial der Scheibe in der Senkrechten der Gate-Elektrode (5) eingebettet ist, und aus einem Anschlußklötzchen (6), dadurch gekennzeichnet, daß es folgende Herstellungsschritte umfaßt:

a) Bildung einer epitaktischen Schicht (2) von hoher Resistivität auf einer Halbleiterscheibe von hoher Resistivität,

b) auf der im Schritt (a) gebildeten Schicht werden Ablagerungen aus einem hitzebeständigen Metall und von sehr geringer Dicke derart vorgenommen, daß das zusätzliche Gate (6, 7) und zwei Markierungen (31, 32) von verschiedener Gestalt gebildet werden,

c) Bildung einer epitaktischen Schicht (21) von geringer Resistivität im Vergleich zu der im Schritt (a) gebildeten Schicht, wobei die Dicke dieser Schicht von geringer Resistivität ausreichend gering ist und die Breite des Metallstäbchens (7) ausreichend klein gegenüber den Abmessungen des Anschlußklötzchens (6) ist, damit ihr epitaktisches Wachsen die Bedeckung des metallischen Stäbchens (7) gestattet, wobei wenigstens ein Teil des genannten Klötzchens (6) und der zwei Markierungen (31, 32) unbedeckt bleibt,

d) Aufbringen von Ohmschen Source- (3) und Drain-Kontakten (4) auf der im Schritt (3) gebildeten epitaktischen Schicht (21),

e) Aufbringen eines Schottky-Gates (5) auf der im Schritt (c) gebildeten epitaktischen Schicht (21) gegenüber dem metallischen Stäbchen (7) des zusätzlichen Gates.

2. Herstellungsverfahren nach Anspruch 1, dadurch gekennzeichnet, daß die Halbleiterscheibe aus halbisolierendem Galliumarsenid ist, wobei die im Schritt (a) gebildete epitaktische Schicht (2) mit $10^{13}$ Atomen/cm³ n-dotiert ist, wobei die metallischen Ablagerungen, die im Schritt (b) gebildet werden, aus Wolfram von einer Dicke von 50 bis 100 nm sind und die im Schritt (c) gebildete epitaktische Schicht (21) mit $10^{17}$ Atomen/cm³ dotiert ist und eine Dicke aufweist, die 300 nm nicht überschreitet.

## Claims

1. Method of Producing a field effect transistor of the type comprising source (3), gate (5) and drain (4) electrodes which are substantially arranged on the same face of a semiconductor chip (10) and further comprising an additinal gate electrode which is accessible from the same face as the preceding electrodes, said additional gate being formed of at least one metallic rod (7) embedded into the semiconductor material of the chip abeam the gate electrode (5) and of a connection block (6), characterized in that it comprises the following steps:

a) forming an epitaxial layer (2) of high resistivity on a semi-conductor wafer of high resistivity;

b) applying deposits of heat-resistive metal and of a very low thickness on the layer formed in step (a) in a manner to constitute the additional gate (6) and two marks (31, 32) of different patterns,

c) forming an epitaxial layer (21) of low resistivity compared to the layer formed in step (a), the thickness of this layer of low resistivity being sufficiently small and the width of the metallic rod (7) being sufficiently small compared to the dimensions of the connection block (6) so that its epitaxial growing permits the metallic rod (7) to be covered while at least a portion of said block (6) and the two marks (31, 32) remain bare,

d) deposition of ohmic source (3) and drain (4) contacts on the layer (21) epitaxially formed in step (c),

e) deposition of a Schottky gate (5) on the epitaxial layer (21) formed in step (c) in facing relationship to the metallic rod (7) of the additional gate.

2. Production mehtod according to claim 1, characterized in that the semi-conductor wafer is of semi-insulating gallium arsenide, the epitaxial layer (2) formed in step (a) being n-doped at $10^{13}$ at cm³, the metallic deposits formed in step (b) being of tungsten and of a thickness from 50 to 100 nm, and the epitaxial layer (21) formed in step (c) being doped at $10^{17}$ at/cm³ and having a thickness not exceeding 300 nm.

FIG.1

FIG.2

FIG.3

# FIG.4

# FIG.5

# FIG.6

GaAs $10^{17} cm^{-3}$    (n)

GaAs $10^{13} cm^{-3}$    (n)

GaAs    (S.I.)